Europäisches Patentamt

European Patent Office

Office européen des brevets

(19)

(11) **EP 1 119 848 B1**

(12) **EUROPÄISCHE PATENTSCHRIFT**

(45) Veröffentlichungstag und Bekanntmachung des Hinweises auf die Patenterteilung:
**19.11.2003 Patentblatt 2003/47**

(21) Anmeldenummer: **99941355.2**

(22) Anmeldetag: **13.09.1999**

(51) Int Cl.⁷: $G11B\ 7/24$

(86) Internationale Anmeldenummer:
**PCT/CH99/00431**

(87) Internationale Veröffentlichungsnummer:
**WO 00/021079 (13.04.2000 Gazette 2000/15)**

(54) **OPTISCHE DATENSPEICHERSCHEIBE**

OPTICAL DATA STORAGE DISK

DISQUE OPTIQUE NUMERIQUE

(84) Benannte Vertragsstaaten:
**AT BE CH CY DE DK ES FI FR GB GR IE IT LI LU MC NL PT SE**

(30) Priorität: **02.10.1998 CH 200998**
**24.12.1998 CH 256398**

(43) Veröffentlichungstag der Anmeldung:
**01.08.2001 Patentblatt 2001/31**

(60) Teilanmeldung:
**02020133.1 / 1 271 501**

(73) Patentinhaber: **Unaxis Balzers Aktiengesellschaft**
**9496 Balzers (LI)**

(72) Erfinder:
• **WEINZERL, Helfried**
**A-6800 Feldkirch (AT)**

• **DUBS, Martin**
**CH-7304 Maienfeld (CH)**

(74) Vertreter: **Troesch Scheidegger Werner AG**
**Schwäntenmos 14**
**8126 Zumikon (CH)**

(56) Entgegenhaltungen:
**EP-A- 0 406 569**          **EP-A- 0 720 159**
**WO-A-99/67084**          **GB-A- 2 017 379**
**US-A- 5 419 939**          **US-A- 5 620 767**
**US-A- 5 640 382**          **US-A- 5 673 251**

• **PATENT ABSTRACTS OF JAPAN vol. 011, no. 253 (P-606), 18. August 1987 (1987-08-18) & JP 62 060108 A (KOBE STEEL LTD), 16. März 1987 (1987-03-16)**

**Beschreibung**

Die vorliegende Erfindung betrifft eine optische Datenspeicherscheibe, bei der, von einer Scheibenoberfläche in Richtung der Scheibendickenausdehnung fortschreitend, mindestens zwei Grenzflächen vorgesehen sind, welche je, entsprechend gespeicherter Information, profiliert sind und wobei die zuinnerst gelegene, profilierte Grenzfläche eine Reflexionsschicht, die mindestens eine, weitere profilierte Grenzfläche eine teilreflektierende/teiltransmittierende Schicht aufweist, je für Licht gegebener Wellenlänge und unter gleichen Einfallswinkeln < 90°, wobei weiter das übrige Scheibenmaterial zwischen der Oberfläche und der Reflexionsschicht das erwähnte Licht im wesentlichen transmittiert, wobei die Reflexionsschicht aus einer ersten Metalllegierung, die Teilreflexionsschicht aus einer zweiten Metalllegierung besteht.

Eine derartige Datenspeicherscheibe ist aus der US-A-5 640 382 bekannt. Von der einen Scheibenoberfläche in Richtung der Scheibendickenausdehnung fortschreitend, weist sie erst ein transparentes Substrat auf, dann eine teilreflektierende Schicht auf einer ersten informationsprofilierten Grenzfläche, dann eine transmittierende Abstandsschicht und schliesslich eine hochreflektierende Schicht auf einer zweiten informationsprofilierten Grenzschicht.

Das erstgenannte transparente Substrat kann dabei aus einem Polymermaterial sein, wie beispielsweise Polycarbonat oder aus amorphem Polyolefin. Anderseits sei es auch möglich, hierfür Glas oder ein Polymethylmetacrylat einzusetzen. Bekanntlich (a.a.O.) kann dieses Substrat auch aus PMMA bestehen.

Die Abstandshalteschicht besteht weiter beispielsweise aus einem Polymer. Die hochreflektierende Schicht für Laserlicht zwischen 600 und 850 nm wird aus Aluminium, Gold, Silber, Kupfer oder einer ihrer Legierungen gebildet. Der Wellenlängenbereich des Laserlichtes kann, wie andernorts erwähnt, bis 500 nm reichen.

Bevorzugt wird gemäss der erwähnten US-PS für die teilreflektierende Schicht Gold eingesetzt, aufgrund seiner optischen Eigenschaften und insbesondere seiner Stabilität gegenüber Umwelteinflüssen. Es wird allerdings erkannt, dass Gold teuer ist. Deshalb wird für die erwähnte teilreflektierende Schicht weiter vorgeschlagen, Gold mit einem weniger teuren Metall zu legieren, um die Kosten zu reduzieren. Dabei wird an der Legierung der teilreflektierenden Schicht mindestens 10 at% Gold, bevorzugt bis 20 at% Gold, beibehalten, um die Stabilität gegenüber Umwelteinflüssen aufrechtzuerhalten.

Als Goldlegierungsmetall wird Silber oder Kupfer vorgeschlagen.

Die US-5 640 382 wird bezüglich Aufbau eines optischen Datenspeichers, von dem die vorliegende Erfindung ausgeht, als integrierter Bestandteil der vorliegenden Erfindung eingeführt.

Bei solchen optischen Datenspeicherscheiben, ausgebildet z.B. als DVD9, Digital Versatile Disk, gemäss Definitionen im DVD-Standard "DVD Specifications for Read-Only Disks", Version 1.0 of August 1966, wird gefordert, dass bei einer gegebenen Wellenlänge von Laserlicht, insbesondere bei 650 nm, das aufgrund der Reflexionen sowohl an der teilreflektierenden Schicht wie auch an der reflektierenden Schicht wieder austretende Laserlicht je 18 bis 30 % des vom Laser eingestrahlten Lichtes betragen müssen. Als DVD9 wird heute verstanden eine "single sided dual layer disc."

Aus der EP-A-0 406 569 sowie der US-A-5 620 767 sind metallische Legierungen bekannt, zur Ausbildung optisch reflektierender Speicherschichten in Datenspeicherscheiben.

An diesen Speicherscheiben wirkt auf einfallendes Licht eine reflektierende Schicht.

Im weiteren wird auf die WO 00/67084 hingewiesen, die erst nach dem Anmeldetag vorliegender Erfindung veröffentlicht wurde.

Es ist Aufgabe der vorliegenden Erfindung, eine optische Datenspeicherscheibe eingangs genannter Art vorzuschlagen, welche

•   diese Spezifikationen bezüglich Strahlaufteilung einhält,

•   in der Fertigung jedoch wesentlich kostengünstiger ist und

•   deren Schichten eine chemische Beständigkeit gegenüber Umwelteinflüssen aufweisen, wie z.B. bezüglich Korrosion, welche Anforderungen in ähnlichem Masse wie vorbekannte Datenspeicherscheiben erfüllen.

Diese Aufgabe wird an der erwähnten Datenspeicherscheibe dadurch gelöst, dass

•   die Legierungen der mindestens zwei Schichten ein oder mehrere gleiche Metalle enthalten, wobei das eine oder die mehreren Metalle gemeinsam einen Anteil von mehr als 50 at% der jeweiligen Legierung ausmachen,

•   falls die Legierungen Gold enthalten, dies nur zu einem Anteil von höchstens 50 at% der jeweiligen Legierung.

Dadurch, dass die Legierung ein oder mehrere gleiche Metalle enthält, mit einem Anteil an der jeweiligen Legierung von mehr als 50 at% wird es möglich, mindestens für diesen jeweiligen Legierungsteil dieselbe Beschichtungsquellenanordnung einzusetzen. Dadurch wird die Basis geschaffen, den Fertigungsprozess für die erwähnten Datenscheiben wesentlich zu rationalisieren. Dadurch, dass weiter, wenn überhaupt Gold an der einen und/oder andern der Legierungen vorgesehen wird, dies nur mit einem Anteil von höchstens 50 at% des Legierungsmaterials erfolgt, wird weiter erreicht, dass auch aufgrund der Kosten für die verwendeten Legierungsmaterialien selber die erfindungsgemässe Scheibe in der Fertigung kostengünstig wird.

Obwohl es durchaus möglich ist, die erwähnten mehreren gleichen Metalle, welche einen Anteil > 50 at% am jeweiligen Legierungsmaterial bilden, schichtspezifisch mit unterschiedlichen Anteilen vorzusehen, wird in einer bevorzugten Ausführungsform vorgeschlagen, die erwähnten gleichen Metalle an den Legierungen mit gleichen Anteilen vorzusehen, dabei vorzugsweise auch den Anteil der Gesamtheit dieser gleichen Metalle am Legierungsmaterial gleich auszubilden.

Dadurch wird ermöglicht, eine Beschichtungsquellenanordnung für die erwähnten gleichen Metalle schichtunspezifisch bei Ablegen beider Schichten gleich zu betreiben.

In einer weiteren bevorzugten Ausführungsform wird weiter vorgeschlagen, dass die Legierungen als Ganzes durch gleiche Metalle, dabei vorzugsweise mit denselben Legierungsanteilen, gebildet sind. Dabei können selbstverständlich weitere Elemente wie N, O, Ar in Spuren enthalten sein. Damit können die Schichten anschliessend mittels der gleichen Beschichtungsquellenanordnung abgelegt werden.

In einer ersten, besonders bevorzugten Ausführungsform der erfindungsgemässen Datenspeicherscheibe sind die erwähnten gemeinsamen, je mehr als 50 at% der jeweiligen Legierungsmaterialien ausmachenden Metalle bzw. bestehen, insbesondere bevorzugt, die Legierung als Ganzes aus

$$Ag_x Ma_y Mb_z$$

oder aus

$$Cu_x Ma_y Mb_z$$

mit x > 50 %, wobei x, schichtspezifisch, im angegebenen Rahmen durchaus variieren kann. Es bezeichnen Ma und Mb ein Zweit- bzw. Drittmetall.

Weiter wird in einer besonders bevorzugten Ausführungsform, insbesondere bei Einsatz von $Ag_x Ma_y Mb_z$, vorgeschlagen, als Zweitmetall Ma Palladium einzusetzen mit y > z, d.h. mit einem höheren Anteil als ein ggf. vorgesehenes Drittmetall Mb. Es sei darauf hingewiesen, dass alle in vorliegender Beschreibung sowie den Ansprüchen aufgeführten Grössenangaben für x, y, z sich als at% von 100 at% Schichtmaterial-Legierung verstehen.

Dabei wird weiter vorgeschlagen, dass gilt:

$$0 < y \leq 10,$$

bevorzugt

$$1 \leq y < 10$$

und

$$0 < z \leq 10,$$

bevorzugt

$$1 \leq z < 10.$$

was besagt, dass wenn die obgenannten Legierungen aus den erwähnten drei Metallen bestehen, sich jeweils für Ag bzw. Cu ergibt:

$$x = 100 - y - z.$$

In einer weiteren bevorzugten Ausführungsform ohne Drittmetall gilt:

$$0 < y \leq 15,$$

bevorzugt

$$1 \leq y < 15$$

und

$$z \approx 0,$$

was zu Silber-Palladium-Legierungsschichten und/oder Cu-Palladium-Schichten führt, Silber-Palladium-Schichten dabei klar bevorzugt.

Dabei wird weiter vorgeschlagen, dass gilt:

$$5 \leq y \leq 10,$$

bevorzugt

$$5 < y < 10$$

und

$$z \approx 0,$$

was insbesondere bei Silberlegierungsschichten mit Palladium, bevorzugt bei Schichten ausschliesslich aus der Silber-Palladium-Legierung, bevorzugt ist.

Insbesondere hierfür, nämlich für den Einsatz von Silber-Palladium-Legierungen wird vorgeschlagen zu wählen:

$$y = 8 \text{ und } z \approx 0.$$

Obwohl die angegebenen Werte auch für

$$Cu_x, Ma_y, Mb_z$$

bevorzugt gelten, insbesondere auch für Kupfer-Palladium-Legierungen, wird weitaus bevorzugt je eine Silber-Palladium-Legierung oder eine Legierung, die jeweils Silber und Palladium zu mehr als 50 at% Anteil umfasst, eingesetzt.

Als das oben angegebene Zweit- oder Drittmetall Ma bzw. Mb, insbesondere als Ma, in diesem Fall anstelle des oben angegebenen bevorzugten Palladiums, kann auch Gold eingesetzt werden mit

$$y > z.$$

Wird für die erwähnten mindestens zwei Schichten dieselbe Legierung eingesetzt und mithin der Brechungsindex beider Legitierungen mit n, der Absorptionskoeffizient mit k bezeichnet, so gilt bevorzugterweise

$$0 < n/k \leq 0{,}28,$$

besonders bevorzugt

$$0 < n/k \leq 0{,}20.$$

Dies gilt bei Licht mit $\lambda = 650$ nm und dem Schichtmaterial in Bulkform vorliegend. Dabei entsprechen die Verhältnisse an der Reflexionsschicht aufgrund ihrer Dicke weitestgehend den Verhältnissen am Bulk. Im weiteren gilt für jede Metalllegierung $k > 2$.

In einer weiteren bevorzugten Ausführungsform der erfindungsgemässen Datenspeicherscheibe ist die Stabilität der optischen Eigenschaften, insbesondere der Schichten, also Reflexion, Transmission, Absorption, besser als $\pm 2$ %, vorzugsweise gar besser als $\pm 1$ %, wenn während 24 h Luft ausgesetzt.

Ein erfindungsgemässes Herstellungsverfahren zeichnet sich nach dem Wortlaut von Anspruch 11 aus, eine bevorzugte Ausführungsvariante nach Anspruch 12.

Die Erfindung wird anschliessend beispielsweise anhand von Figuren erläutert. Es zeigen:

Fig. 1   schematisch einen Querschnitt durch eine optische Datenspeicherscheibe mit Doppelinformationsträger-Grenzfläche,

Fig. 2   einen Verlauf der Absorption in Funktion des Verhältnisses n/k von Schichtmaterial,

Fig. 3a   bei einer bevorzugten Ausführungsform einer erfindungsgemässen optischen Datenspeicherscheibe, die an den teilreflektierenden Schichten unmittelbar nach ihrer Fertigung gemessenen Absorptions-, Transmissions- und Reflexionsverhältnisse,

Fig. 3b   in Darstellung analog zu Fig. 2a, die erwähnten Verhältnisse nach 13 Std. Luftlagerung,

Fig. 3c   in Darstellung analog zu den Fig. 2a und 2b die erwähnten Verhältnisse nach 37,5 Std. Luftlagerung.

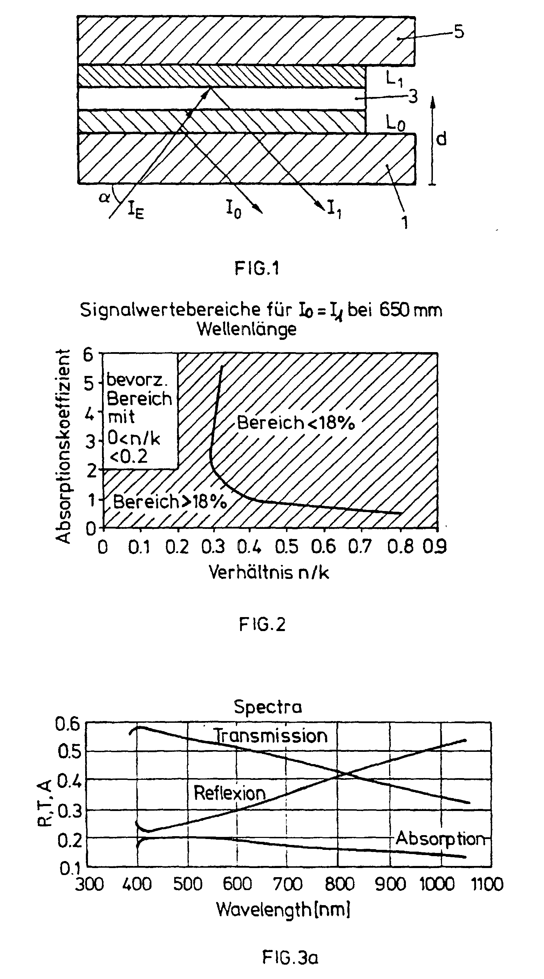

In Fig. 1 ist schematisch eine optische Datenspeicherscheibe der in vorliegender Anmeldung angesprochenen Art dargestellt. Sie umfasst, in Richtung d von einer der Scheibenflächen ausgehend nach innen fortschreitend, ein insbesondere für Licht mit $\lambda = 650$ nm transparentes Substrat 1, vorzugsweise aus Polycarbonat, dem sich eine teilreflektierende, teiltransmittierende Schicht $L_0$ anschliesst. Es folgt eine Abstandshalteschicht 3, beispielsweise eine Klebeschicht, ebenfalls insbesondere für das erwähnte Licht transmittierend, sowie eine reflektierende Schicht $L_1$, alles auf einem Träger 5, wie beispielsweise wiederum aus Polycarbonat. An den Grenzflächen 1/3 und 3/5 je mit vorgesehener Schicht $L_0$, $L_1$ sind die Informations-Prägemuster vorgesehen.

Laserlicht $I_\varepsilon$ mit 500 nm $\leq \lambda \leq$ 8580 nm, vorzugsweise mit $\lambda = 650$ nm, wird unter einem Winkel $\alpha < 90°$ auf die Speicherscheibe gerichtet und wird an der teilreflektierenden Schicht $L_0$ teilreflektiert, um mit dem Anteil $I_0$ wieder auszutreten. An $L_0$ teiltransmittiertes Licht wird an der reflektierenden Schicht $L_1$ weitestgehend vollreflektiert und tritt mit dem Anteil $I_1$ aus.

Wird gemäss einer weitaus bevorzugten Ausführungsform der vorliegenden Erfindung vorausgesetzt, dass die Metalllegierungen der Schichten $L_1$ und $L_0$ gleich sind, so kann für beide Legierungen der Brechungsindex zu näherungsweise n und der Absorptionskoeffizient zu k gesetzt werden. Dabei ist der Absorptionskoeffizient k für Metalle bzw. Metalllegierungen üblicherweise $k > 2$.

In Fig. 2 ist der Verlauf des Absorptionskoeffizienten in Funktion des Verhältnisses n/k wie gerechnet aufgetragen. Dabei wurde davon ausgegangen, dass die Signale $I_0$ und $I_1$ perfekt ausbalanciert sind, weiter die Reflexionsverteilung über die Disc-Scheibe perfekt ist ($\pm 0$ %) sowie keine weiteren Verluste auftreten. Es ist aus Fig. 2 ersichtlich, dass ein n/k-Verhältnis einzuhalten ist, für welches gilt:

$$0 < n/k \leq 0{,}28,$$

dabei bevorzugt

$$0 < n/k \leq 0{,}20,$$

damit die Signalwerte grösser als 18 % werden können.

Dabei gilt der in Fig. 2 gezeigte Verlauf weiter für Licht mit einer Wellenlänge $\lambda$ = 650 nm sowie für Bulkmaterial. Die Verhältnisse an der Reflexionsschicht $L_1$ gemäss Fig. 1 entsprechen weitgehendst den optischen Verhältnissen am Bulkmaterial.

Real ist mit folgenden Einflüssen zu rechnen:

Signalverluste von 5 bis 10 %, beispielsweise durch Doppelbrechung im Substrat 1, Streuungsverluste durch die Informationseinprägemuster,

Reproduzierbarkeit der Reflexion, Reflexionsverteilung entlang dem Disk, welche ± 1 % bzw. ± 1,5 % betragen dürften. Das an Bulkverhältnissen gerechnete Signal, weitestgehend $I_1$ von Fig. 1 entsprechend, soll grösser als 22 bis 23 % $I_E$ sein, damit, in einer industriellen Massenproduktion, das Signal weiterhin > 18 % bleibt. Für diese industrielle Produktion ist mithin bevorzugt von

$$0 < n/k \leq 0{,}2$$

auszugehen, um geringstmöglichen Ausschuss zu gewährleisten.

Bei der Legierungsauswahl, bevorzugt für gleiche Legierungen mit gleichen Metallanteilen an beiden Schichten $L_0$, $L_1$, ergeben sich unter Einhalt der geforderten chemischen Beständigkeit sowie möglichst geringer Goldanteile vorerst folgende Legierungen als Universalschichtmaterialien:

• Silber-Palladium-Legierungen

Es wurde durch DC-Sputtern eines Silber-Palladium-Legierungstargets $Ag_{92}Pd_8$-Schichten abgelegt. Als Reflexionsschicht $L_1$ wurde die Legierungsschicht mit einer Dicke > 60 nm, bevorzugt > 75 nm abgelegt. Gesputtert wurde mit einer Aufwachsrate von 13 nm/kWsec. Die optischen Werte entsprechen weitestgehend den optischen Werten der Silber-Palladium-Legierung als Bulk. Folgende Werte wurden gemessen:

| Reflexion | 90 % |
|-----------|------|
| Absorption | 10 % |

(fortgesetzt)

| n | 0,511 |
|-----|-------|
| k | 3,74 |
| n/k | 0,136 |

Aus diesen Werten ist ersichtlich, dass für die vorerwähnte Silber-Palladium-Legierung ein n/k-Wert von 0,136 resultiert. Für die ermittelten Werte am Bulkmaterial kann nun rechnerisch eine geeignete Schichtdicke von 13 bis 17 nm für die teilreflektierende Schicht gemäss $L_o$ von Fig. 1 ermittelt werden.

Für eine solche teilreflektierende Schicht ergab sich das in Fig. 3a wiedergegebene optische Verhalten bezüglich Transmission, Reflexion und Absorption, dies unmittelbar nach ihrer Fertigung.

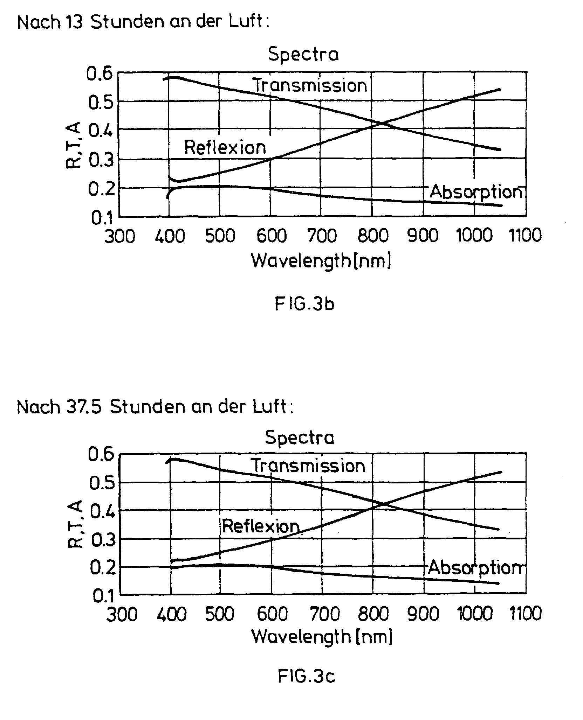

Nach 13 Std. ergaben sich Verläufe nach Fig. 3b und schliesslich, nach 37,5 Std. Luftlagerung gemäss Fig. 3c.

Daraus lässt sich folgern, dass erfindungsgemäss vorgesehene Schichten äusserst stabil realisiert werden können, mit einer Stabilität ihrer optischen Eigenschaften, nämlich von Reflexion, Transmission und Absorption im gesamten erfassten Bereich von 500 bis 900 nm von besser als ± 2 %, wenn sie mindestens 24 h an Luft gelagert werden. Die besonders bevorzugte Silber-Palladium-Legierung ergibt gemäss den angeführten Figuren eine Stabilität gar besser als ± 1 %.

Dieses Material kann durch einen herkömmlichen DC-Sputterprozess mit sehr hoher Rate abgelegt werden. Verglichen mit einer Goldbeschichtung liegen die Kosten einer Silber-Palladium-Beschichtung ca. 80 % bis 90 % tiefer.

Somit ist mit der erwähnten Silber-Palladium-Legierung ein Universalmaterial für Schichten an optischen Datenscheiben obgenannter Art gefunden.

Weitere Silber-Palladium-Legierungen $Ag_xPd_y$ mit Legierungsanteilen y von Palladium $0 < y \leq 15$, bevorzugt von $1 \leq y < 15$ und mithin x = 100 - y lassen sich mit ähnlich guten Resultaten einsetzen, ebenso wie Legierungen $Ag_xPd_yMb_z$ mit $0 < y \leq 10$, bevorzugt von $1 \leq y < 10$ und $0 < z \leq 10$, bevorzugt $1 \leq z < 10$. $M_b$ kann dabei beispielsweise Gold sein.

Nachdem durch Experimente an Silber-Palladium-Legierungen die Gesetzmässigkeiten und die Machbarkeit der Lösung der der vorliegenden Erfindung zugrundegelegten Aufgabe aufgefunden wurde, ergibt sich, dass beispielsweise auch Silber-Gold-Legierungen sich für beide Schichten als Universalmaterialien eignen, weist doch eine $Ag_{60}Au_{40}$-Legierung einen n/k-Wert von 0,079 und eine $Ag_{50}Au_{50}$-Legierung einen n/k-Wert von 0,108 auf.

Es können alle Legierungen $Ag_xAu_y$ mit $0 < y < 50$, bevorzugt mit $1 \leq y < 50$ und mithin x = 100 - y bzw. Legierungen $Ag_xAu_yMb_z$ mit x > 50, $0 < y < 50$, bevorzugt $1 \leq y < 50$, $0 < z \leq 10$, bevorzugt $1 \leq z < 10$ und mithin x = 100 - y - z als Universalmaterialien in Betracht gezogen werden.

Auch Kupfer-Gold-Legierungen zeigten sich für Universalmaterial geeignet:

$Cu_{50}Au_{50}$-Legierungen haben n/k-Werte von 0,142,

$Cu_{60}Au_{40}$ von 0, 156.

Generell können alle Legierungen $Cu_xAu_y$ mit $0 < y < 50$, bevorzugt $1 \leq y < 50$ und mithin $x = 100 - y$ bzw. Legierungen $Cu_xAu_yMb_z$ mit $x > 50$, $0 < y < 50$, bevorzugt $1 \leq y < 50$ und $0 < z \leq 10$, bevorzugt $1 \leq z < 10$ und mithin $x = 100 - y - z$ als Universalmaterialien eingesetzt werden. Dies gilt auch für Kupfer-Zinn-Legierungen (Bronzen) sowie für Kupfer-Palladium-Legierungen.

Bei der Herstellung der optischen Datenspeicherscheiben wird für alle Schichten eine Hauptbeschichtungsquelle eingesetzt, bevorzugt sogar nur eine Beschichtunsgsquelle für alle Schichten. Hierzu eignet sich besonders eine DC-Sputterquelle, wie DC-Magnetronquelle, mit dem vorgesehenen Legierungsanteil als Targetmaterial. Ggf. von Schicht zu Schicht variierende Metallanteile können an diesen Quellen durch unterschiedliche Prozessführung eingestellt werden. Im weiteren kann beim Ablegen der Schichten ein äusserst geringer Substrat/Quellenabstand eingehalten werden, und das Substrat kann bezüglich der Quelle stationär beschichtet werden, was gesamthaft zu kompakten, kostengünstigen Herstellungsanlagen führt.

Bezüglich der besonders bevorzugten Silber-Palladium-Legierung kann weiter ausgeführt werden, dass diese gegenüber Umwelteinflüssen ganz besonders stabil ist und bei ihrer Herstellung mit einem hohen Sputter-Yield ablegbar ist.

Die vorgeschlagenen Universalmaterialien sind wesentlich billiger als Gold. Aufgrund der Merkmale, mindestens einen Grundlegierungsanteil an beiden Schichten aus den gleichen Metallen zu bilden, bevorzugt die Schichten aus gleichen Legierungen zu fertigen, ist es möglich, die erfindungsgemässen Datenspeicherscheiben an einer einzigen Beschichtungsanlage, insbesondere Sputteranlage, vorzugsweise durch Einsatz einer einzigen Quelle zu realisieren.

## Patentansprüche

1. Optische Datenspeicherscheibe, bei der, von einer Scheibenoberfläche in Richtung der Scheibendikkenausdehnung fortschreitend, mindestens zwei Grenzflächen vorgesehen sind, welche je, entsprechend gespeicherter Information, profiliert sind und wobei die zuinnerst gelegene, profilierte Grenzfläche eine Reflexionsschicht, die mindestens eine, weitere profilierte Grenzfläche eine teilreflektierende/teiltransmittierende Schicht aufweist, je für Licht gegebener Wellenlänge und unter gleichen Einfallswinkeln < 90°, wobei weiter das übrige Scheibenmaterial zwischen der Oberfläche und der Reflexionsschicht das erwähnte Licht im wesentlich transmittiert, und weiter die Reflexionsschicht aus einer ersten Metalllegierung, die Teilreflexionsschicht aus einer zweiten Metalllegierung bestehen, **dadurch gekennzeichnet,**

- **dass** die Legierungen der mindestens zwei Schichten ein oder mehrere gleiche Metalle enthalten, wobei das eine oder die mehreren Metalle gemeinsam einen Anteil von mehr als 50 at% der jeweiligen Legierung ausmachen,

- falls die Legierungen Gold enthalten, dies nur zu einem Anteil von höchstens 50 at% der jeweiligen Legierung.

2. Datenspeicherscheibe nach Anspruch 1, **dadurch gekennzeichnet, dass** die Legierungen das erwähnte gleiche Metall oder die erwähnten gleichen Metalle mit gleichen Anteilen aufweisen.

3. Datenspeicherscheibe nach einem der Ansprüche 1 oder 2, **dadurch gekennzeichnet, dass** die Legierungen durch gleiche Metalle, vorzugsweise mit gleichen Anteilen, gebildet sind.

4. Datenspeicherscheibe nach einem der Ansprüche 1 bis 3, **dadurch gekennzeichnet, dass** die gleichen Metalle oder die Legierungen bestehen aus:

$$Ag_xMa_yMb_z$$

oder aus

$$Cu_xMa_yMb_z$$

mit $x > 50$ at%, wobei bezeichnen

Ma:    ein Zweitmetall

Mb:    ein Drittmetall.

5. Datenspeicherscheibe nach Anspruch 4, bei der die gleichen Metalle oder die Legierungen bestehen aus

$$Ag_xMa_yMb_z,$$

**dadurch gekennzeichnet, dass** das Zweitmetall Ma Palladium ist und gilt $y > z$.

6. Datenspeicherscheibe nach Anspruch 4 oder 5, **dadurch gekennzeichnet, dass** gilt:

$$0 < y \leq 10,$$

bevorzugt

$$1 \leq y < 10$$

und

$$0 < z \leq 10,$$

bevorzugt

$$1 \leq z < 10.$$

7. Datenspeicherscheibe nach einem der Ansprüche 4 oder 5, **dadurch gekennzeichnet, dass** insbesondere bevorzugt für $Ag_xPd_y$-Legierungsschichten gilt:

$$0 < y \leq 15,$$

bevorzugt

$$1 \leq y < 15$$

und

$$z \approx 0,$$

dabei vorzugsweise gilt:

$$5 \leq y \leq 10,$$

bevorzugt

$$5 < y < 10,$$

$$z \approx 0,$$

besonders bevorzugt gilt:

$$y = 8, z \approx 0.$$

8. Datenspeicherscheibe nach einem der Ansprüche 5 bis 7, **dadurch gekennzeichnet, dass** gilt:

$$Ma = Au,$$

mit

$$y > z.$$

9. Datenspeicherscheibe nach einem der Ansprüche 1 bis 8, **dadurch gekennzeichnet, dass** die Legierungen beider Schichten gleich sind und für das Verhältnis von Brechungsindex zu Absorptionskoeffizienten n/k an der Legierung als Bulk und bei Licht von 650 nm gilt

$$0 < n/k \leq 0{,}28,$$

vorzugsweise

$$0 < n/k \leq 0{,}20.$$

10. Datenspeicherscheibe nach einem der Ansprüche 1 bis 9, **dadurch gekennzeichnet, dass** die Stabilität ihrer teilreflektierenden/teiltransmittierenden bzw. reflektierenden Eigenschaften besser als $\pm$ 2 %, vorzugsweise besser als $\pm$ 1 % ist, gemessen bei Luft-Exposition während 24 h, wobei vorzugsweise die Legierungen kein Gold enthalten.

11. Verfahren zur Herstellung einer optischen Speicherscheibe nach einem der Ansprüche 1 bis 10, **dadurch gekennzeichnet, dass** man die mindestens zwei Schichten durch DC-Sputtern derselben Metalllegierung ablegt.

12. Verfahren nach Anspruch 11, **dadurch gekennzeichnet, dass** man die Schichten durch DC-Sputtern desselben Targets ablegt.

**Claims**

1. Optical data storage disk in which, progressing from one disk surface in the direction of the thickness extension, at least two limit surfaces are provided which are each profiled according to information stored and where the innermost profiled limit surface has a reflective layer, the at least one further profiled limit surface has a partly reflective/partly transmissive layer, each for light of given wavelength and at the same angles of incidence of less than 90°, where furthermore the remaining disk material between the surface and the reflective layer essentially transmits the said light and furthermore the reflective layer consists of a first metal alloy, the partly reflective layer consists of a second metal alloy, **characterised in that**

- the alloys of the at least two layers contain one or more same metals, where the one or more metals together make up a proportion of more than 50 at% of the alloy concerned,
- if the alloys contain gold, this is only to a proportion of maximum 50 at% of the alloy concerned.

2. Data storage disk according to claim 1, **characterised in that** the alloys have the said same metal or the said same metals with the same proportions.

3. Data storage disk according to one of claims 1 or 2, **characterised in that** the alloys are formed by the same metals, preferably with the same proportions.

4. Data storage disk according to any of claims 1 to 3, **characterised in that** the same metals or the alloys consist of:

$$Ag_xMa_yMb_z$$

or

$$Cu_xMa_yMb_z$$

with $x > 50$ at%, where
   Ma: is a second metal
   Mb: is a third metal.

5. Data storage disk according to claim 4, in which the same metals or alloys consist of

$$Ag_xMa_yMb_z,$$

**characterised in that** the second metal Ma is palladium and $y > z$.

6. Data storage disk according to claim 4 or 5, **characterised in that**

$$0 < y \leq 10,$$

and preferably

$$1 \leq y < 10$$

and

$$0 < z \leq 10,$$

preferably

$$1 \leq z < 10.$$

7. Data storage disk according to one of claims 4 or 5, **characterised in that**, particularly preferably for $Ag_xPd_y$ alloy layers:

$$0 < y \leq 15,$$

preferably

$$1 \leq y < 15$$

and

$$z \approx 0,$$

where preferably:

$$5 \leq y \leq 10,$$

preferably

$$5 < y < 10,$$

$$z \approx 0,$$

particularly preferably:

$$y = 8, z \approx 0.$$

8. Data storage disk according to any of claims 5 to 7, **characterised in that**

$$Ma = Au,$$

with

$$y > z.$$

9. Data storage disk according to any of claims 1 to 8, **characterised in that** the alloys of the two layers are the same and for the ratio of refractive index to absorption coefficient n/k in the alloy as bulk and with light of 650 nm, there is valid

$$0 < n/k \leq 0.28,$$

preferably

$$0 < n/k \leq 0.20.$$

10. Data storage disk according to any of claims 1 to 9, **characterised in** the stability of its partly reflective/ partly transmissive or reflective properties is better than $\pm 2\%$, preferably better than $\pm 1\%$, measured at air exposure for 24 hours, where preferably the alloys contain no gold.

11. Process for manufacturing an optical storage disk according to any of claims 1 to 10, **characterised in that** the at least two layers are deposited by DC sputtering of the same metal alloy.

12. Process according to claim 11, **characterised in that** the layers are deposited by DC sputtering of the same target.


**Revendications**

1. Disque optique numérique pour lequel il est prévu à partir d'une surface de disque, dans le sens de l'épaisseur du disque, au moins deux interfaces qui sont profilés en fonction des informations stockées, étant précisé que l'interface profilée intérieure présente une couche de réflexion tandis que l'autre ou les autres interfaces profilées présentent une couche de réflexion partielle/de transmission partielle d'une longueur d'onde définie pour la lumière et suivant des angles d'incidences égaux $< 90°$, que le reste du matériau du disque transmet globalement la lumière mentionnée entre la surface et la couche de réflexion, et que la couche de réflexion se compose d'un premier alliage métallique, et la couche de réflexion partielle d'un second alliage métallique,
     **caractérisé**

   - **en ce que** les alliages des deux couches, ou plus, contiennent un ou plusieurs métaux identiques, le métal ou les métaux représentant ensemble une proportion de plus de 50 %at. de l'alliage,
   - au cas où les alliages contiennent de l'or, l'or ne représente qu'une proportion de 50 %at., au maximum, de chaque alliage.

2. Disque optique numérique selon la revendication 1, **caractérisé en ce que** les alliages contiennent le ou les métaux identiques mentionnés dans des proportions égales.

3. Disque optique numérique selon la revendication 1 ou 2, **caractérisé en ce que** les alliages sont formés par des métaux identiques, de préférence dans des proportions égales.

4. Disque optique numérique selon l'une des revendications 1 à 3, **caractérisé en ce que** les métaux identiques ou les alliages se composent de :

$$Ag_x Ma_y Mb_z$$

   ou de

$$Cu_x Ma_y Mb_z,$$

   avec $x > 50$ %at . , Ma désignant un deuxième métal et Mb un troisième métal.

5. Disque optique numérique selon la revendication 4, dans lequel les métaux identiques ou les alliages se composent de

$$Ag_x Ma_y Mb_z,$$

   **caractérisé en ce que** le deuxième métal Ma est constitué par du palladium, et $y > z$.

6. Disque optique numérique selon la revendication 4 ou 5, **caractérisé en ce qu'**on a :

$$0 < y \leq 10 ,$$

   de préférence

$$1 \leq y < 10,$$

   et

$$0 < z \leq 10,$$

   de préférence

$$1 \leq z < 10.$$

7. Disque optique numérique selon la revendication 4 ou 5, **caractérisé en ce qu'**on a de préférence, plus spécialement, pour les couches d'alliage $Ag_x Pd_y$ :

$$0 < y \leq 15,$$

de préférence

$$1 \leq y < 15,$$

et

$$z \approx 0,$$

de préférence :

$$5 \leq y \leq 10,$$

de préférence

$$5 < y < 10,$$

$$z \approx 0,$$

plus spécialement :

$$y = 8, z \approx 0.$$

8. Disque optique numérique selon l'une des revendications 5 à 7, **caractérisé en ce qu'**on a :

$$Ma = Au,$$

avec

$$y > z.$$

9. Disque optique numérique selon l'une des revendications 1 à 8, **caractérisé en ce que** les alliages des deux couches sont identiques, et pour le rapport de l'indice de réfraction sur le coefficient d'absorption n/k sur l'alliage en vrac et avec une lumière de 650 nm, on a

$$0 < n/k \leq 0,28,$$

de préférence

$$0 < n/k \leq 0,20.$$

10. Disque optique numérique selon l'une des revendications 1 à 9, **caractérisé en ce que** la stabilité de ses propriétés de réflexion partielle/de transmission partielle ou de ses propriétés de réflexion est supérieure à ± 2 %, de préférence à ± 1 %, mesurée avec une exposition à l'air pendant 24 h, les alliages ne contenant pas d'or, de préférence.

11. Procédé pour fabriquer un disque optique numérique selon l'une des revendications 1 à 10, **caractérisé en ce qu'**on dépose les deux couches, ou plus, par pulvérisation cathodique à courant continu du même alliage métallique.

12. Procédé selon la revendication 11, **caractérisé en ce qu'**on dépose les couches par pulvérisation cathodique à courant continu de la même cible.

FIG.1

Signalwertebereiche für $I_0 = I_1$ bei 650 mm
Wellenlänge

FIG.2

Spectra

FIG.3a

Nach 13 Stunden an der Luft:

FIG.3b

Nach 37.5 Stunden an der Luft:

FIG.3c